(19) Europäisches Patentamt
European Patent Office
Office européen des brevets

(11) **EP 4 047 945 B1**

(12) **FASCICULE DE BREVET EUROPEEN**

(45) Date de publication et mention
de la délivrance du brevet:
**28.06.2023 Bulletin 2023/26**

(21) Numéro de dépôt: **22155290.4**

(22) Date de dépôt: **04.02.2022**

(51) Classification Internationale des Brevets (IPC):
**H04R 1/08** (2006.01)        **H04R 1/34** (2006.01)

(52) Classification Coopérative des Brevets (CPC):
**H04R 1/08; H04R 1/342;** H04R 2201/003;
H04R 2201/029

(54) **EQUIPEMENT ELECTRONIQUE COMPORTANT UN CONDUIT ACOUSTIQUE ETANCHE**

ELEKTRONISCHES GERÄT MIT EINER WASSERDICHTEN AKUSTISCHEN LEITUNG

ELECTRONIC EQUIPMENT COMPRISING A SEALED ACOUSTIC CONDUIT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.02.2021 FR 2101685**

(43) Date de publication de la demande:
**24.08.2022 Bulletin 2022/34**

(73) Titulaire: **SAGEMCOM BROADBAND SAS
92500 Rueil-Malmaison (FR)**

(72) Inventeurs:
• **FERREIRA, Arnaud
92500 RUEIL MALMAISON (FR)**
• **MARTIN DE MONTAUDRY, Charles-Efflam
92500 RUEIL MALMAISON (FR)**

(74) Mandataire: **Lavaud, Thomas
Cabinet Boettcher
5, rue de Vienne
75008 Paris (FR)**

(56) Documents cités:
**WO-A1-2020/032515      WO-A1-2020/143315**

# EP 4 047 945 B1

**Description**

L'invention concerne le domaine des équipements électroniques qui comprennent un ou des microphones.

ARRIERE PLAN DE L'INVENTION

Il existe sur le marché une multitude d'équipements électroniques équipés de microphones.

Parmi ces équipements électroniques, certains comprennent un assistant vocal personnel intégré (Google, Alexa, Siri, etc.). Dans chacun de ces équipements électroniques, la reconnaissance vocale fonctionne grâce à un ou plusieurs microphones disposés de manière adéquate les uns par rapport aux autres afin d'obtenir le meilleur retour audio.

Chaque microphone doit être isolé acoustiquement des autres. Cela signifie que le conduit acoustique entre le milieu ambiant et la membrane du composant microphone doit être parfaitement étanche.

Cette étanchéité est primordiale pour le traitement du signal audio servant à obtenir une reconnaissance vocale performante. Il convient en effet d'éviter qu'un microphone ne capte une partie du signal sonore qui entre dans l'équipement électronique par le conduit acoustique d'un autre microphone. Il convient aussi d'éviter que la captation d'un microphone ne soit perturbée par des bruits internes de l'équipement électronique.

Pour assurer cette étanchéité acoustique, on connaît tout d'abord une première solution de l'art antérieur, dans laquelle le circuit imprimé sur lequel est monté le microphone est vissé par des vis dans le capot en plastique de l'équipement électronique. Un tube de mousse est positionné autour du microphone. Le couple de serrage des vis permet la compression du tube de mousse, le rendant ainsi étanche. Cette architecture va à l'encontre des problématiques de réduction de la taille des équipements électroniques, car elle nécessite des éléments relativement volumineux : fûts de vis, têtes de vis encombrantes, circuit imprimé épais, etc. Les documents WO2020032515 et WO2020143315 montrent des solutions de l'art antérieure.

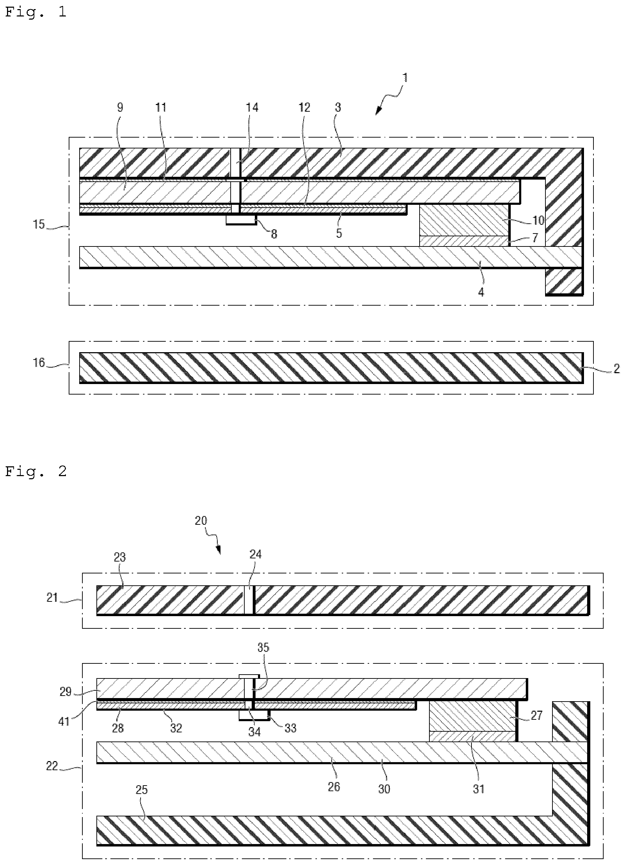

En référence à la figure 1, on connaît aussi une deuxième solution de l'art antérieur.

L'équipement électronique de l'art antérieur 1 comporte un boîtier à l'intérieur duquel est agencé un châssis interne 2 en plastique. Un capot 3 en plastique (par exemple en ABS) permet de refermer le boîtier.

L'équipement électronique 1 comporte deux cartes électroniques : une carte mère 4 et une carte fille 5.

La carte mère 4 comporte un circuit imprimé sur lequel est monté un processeur 7. La carte fille 5 comporte un circuit imprimé sur lequel est monté un microphone 8.

L'équipement électronique 1 comprend aussi un dissipateur thermique 9 en cuivre et une interface thermique 10.

Lorsque l'équipement électronique 1 est assemblé, le dissipateur thermique 9 est fixé au capot 3 par une couche d'adhésif thermique 11. La carte fille 5 est fixée au dissipateur thermique 9 par une couche d'adhésif thermique 12.

L'interface thermique 10 est en contact avec le processeur 7 de la carte mère 4 et avec le dissipateur thermique 9. Le transfert thermique du processeur 7 vers l'extérieur est ainsi assuré via l'interface thermique 10, le dissipateur thermique 9, la couche d'adhésif thermique 11 et le capot 3.

On voit aussi que le capot 3, le dissipateur thermique 9 et la carte fille 5 comprennent chacun un trou. Les trous sont disposés coaxialement pour former un conduit acoustique 14. Le microphone 8 est monté sur une face interne du circuit imprimé de la carte fille 5 (par « interne », on entend ici du côté de l'intérieur de l'équipement électronique lorsque celui-ci est assemblé, et par « externe », on entend du côté de l'extérieur de l'équipement électronique).

Le microphone 8 est ici un microphone omnidirectionnel de type MEMS (pour « microsystème électromécanique »), qui a pour avantage notamment le fait d'avoir un encombrement plus réduit qu'un microphone de type ECM (microphone à condensateur à électret). De plus, le microphone 8 est de type à port inférieur, c'est-à-dire qu'il comporte un trou, formant une entrée pour les signaux sonores, qui est placé sous le boîtier du microphone 8. Ainsi, les signaux sonores provenant de l'extérieur de l'équipement électronique 1 se propagent dans le conduit acoustique 14 et traversent le circuit imprimé de la carte fille 5 pour atteindre la partie sensible du microphone 8.

Les deux couches d'adhésif thermique 11, 12 permettent d'assurer l'étanchéité du conduit acoustique 14 à l'interface entre le capot 3 et le dissipateur thermique 9, et à l'interface entre le dissipateur thermique 9 et la carte fille 5.

Cette solution est nettement meilleure que la précédente du point de vue de l'encombrement.

On constate que l'équipement électronique 1, dans cette solution, comporte un premier sous-ensemble 15 et un deuxième sous-ensemble 16.

Le premier sous-ensemble 15 comprend le capot 3, la carte mère 4, le dissipateur thermique 9 qui est lié au capot 3 via la couche d'adhésif thermique 11, et la carte fille 5 qui est liée au dissipateur thermique 9 via la couche d'adhésif thermique 12.

Le deuxième sous-ensemble 16 comporte uniquement le châssis 2.

Cette solution pose le problème suivant.

Le capot 3 constitue l'interface de l'équipement électronique 1 avec l'extérieur et, de ce fait, peut subir des chocs, des rayures, diverses projections, etc. Or, le capot représente une part importante du caractère esthétique de l'équipement électronique 1, et il est relativement courant qu'un tel équipement électronique soit envoyé au SAV (pour « Service Après-Vente ») du fabricant pour remplacer le capot. Or, comme le capot 3 est lié à la fois au dissipateur thermique 9, à la carte mère 4 et à la carte fille 5, le remplacement du capot 3 implique de remplacer aussi tous ces éléments. L'opération de remplacement du capot 3 est donc onéreuse. De plus, comme les différents composants cités sont indémontables du fait des couches d'adhésif thermique 11, 12 entre les matières plastiques et métalliques, ces différents composants ne peuvent pas être recyclés. Ceci pose à nouveau un problème de coût, mais aussi un problème écologique.

OBJET DE L'INVENTION

L'invention a pour objet, dans un équipement électronique qui comprend un microphone, d'assurer l'étanchéité acoustique du conduit acoustique qui relie le microphone à l'extérieur et de permettre un transfert thermique efficace et ce, de manière peu volumineuse, peu coûteuse et écologique.

RESUME DE L'INVENTION

En vue de la réalisation de ce but, on propose un équipement électronique comportant un premier sous-ensemble et un deuxième sous-ensemble séparables, le premier sous-ensemble comprenant un capot comportant un premier trou, le deuxième sous-ensemble comprenant un circuit imprimé sur lequel est monté au moins un microphone et comprenant un deuxième trou, et un dissipateur thermique comprenant un troisième trou, l'équipement électronique comportant de plus un pad thermique comprenant un quatrième trou, et un élément de compression, l'équipement électronique étant agencé de sorte que, lorsque l'équipement électronique est assemblé, le dissipateur thermique est positionné entre le capot et le circuit imprimé, le pad thermique est positionné entre le capot et le dissipateur thermique, le premier trou, le deuxième trou, le troisième trou et le quatrième trou définissent un conduit acoustique agencé pour permettre au microphone de capter des signaux sonores provenant de l'extérieur de l'équipement électronique, et l'élément de compression comprime le pad thermique autour du conduit acoustique pour assurer une étanchéité acoustique du conduit acoustique au niveau d'une interface entre le capot et le pad thermique et au niveau d'une interface entre le pad thermique et le dissipateur thermique.

L'équipement électronique selon l'invention comprend donc un pad thermique positionné entre le capot et le dissipateur thermique. Le pad thermique permet d'assurer un transfert thermique efficace entre le dissipateur thermique et l'extérieur de l'équipement électronique (via le capot). La compression par l'élément de compression du pad thermique autour du conduit acoustique permet d'assurer l'étanchéité du conduit acoustique.

Il n'y a donc pas de couche adhésive entre le capot et le dissipateur thermique, de sorte que le premier sous-ensemble et le deuxième sous-ensemble sont démontables. Le capot peut donc être remplacé sans que ce remplacement n'oblige à remplacer d'autres composants de l'équipement électronique. Le remplacement est donc peu coûteux, et l'équipement électronique est aisément recyclable.

On note aussi que l'assemblage de l'équipement électronique selon l'invention ne nécessite pas de visser au capot le circuit imprimé sur lequel est monté le microphone, de sorte que l'équipement électronique est peu volumineux.

On propose de plus un équipement électronique tel que précédemment décrit, dans lequel l'élément de compression est une nervure formée sur le capot ou sur le dissipateur thermique.

On propose de plus un équipement électronique tel que précédemment décrit, dans lequel la nervure est formée sur une face interne du capot et s'étend autour du premier trou.

On propose de plus un équipement électronique tel que précédemment décrit, dans lequel la nervure est formée sur une face externe du dissipateur thermique et s'étend autour du troisième trou.

On propose de plus un équipement électronique tel que précédemment décrit, dans lequel la nervure présente une forme annulaire, et dans lequel une largeur l de la nervure égale à une différence entre un rayon extérieur et un rayon intérieur de la nervure, et une hauteur h de la nervure, sont telles que :

$$l \geq 3 \times h.$$

On propose de plus un équipement électronique tel que précédemment décrit, dans lequel une hauteur h de la nervure et une épaisseur e du pad thermique sont telles que :

$$h \geq 0,5 \times e.$$

On propose de plus un équipement électronique tel que précédemment décrit, dans lequel on a :

$$D < C < B < A,$$

où D est un diamètre moyen du premier trou, C est un diamètre moyen du troisième trou, B est un diamètre moyen du quatrième trou et A est un diamètre intérieur de la nervure.

On propose de plus un équipement électronique tel que précédemment décrit, dans lequel le pad thermique comprend du graphite.

On propose de plus un équipement électronique tel que précédemment décrit, dans lequel le circuit imprimé est fixé au dissipateur thermique par une couche d'adhésif thermique.

On propose de plus un équipement électronique tel que précédemment décrit, l'équipement électronique étant une passerelle résidentielle ou un boîtier décodeur.

L'invention sera mieux comprise à la lumière de la description qui suit d'un mode de mise en œuvre particulier non limitatif de l'invention.

BREVE DESCRIPTION DES DESSINS

Il sera fait référence aux dessins annexés parmi lesquels :

[Fig. 1] la figure 1 représente une vue en coupe, selon un plan perpendiculaire à une face du capot, d'un équipement électronique de l'art antérieur ;
[Fig. 2] la figure 2 représente une vue en coupe de l'équipement électronique selon l'invention, le premier sous-ensemble et le deuxième sous-ensemble n'étant pas assemblés ;
[Fig. 3] la figure 3 est une figure similaire à la figure 2, le premier sous-ensemble et le deuxième sous-ensemble étant assemblés ;
[Fig. 4] la figure 4 est une vue de détail de la figure 3 ; [Fig. 5] la figure 5 illustre un phénomène de poinçonnement du pad thermique ;
[Fig. 6] la figure 6 représente le conduit acoustique.

DESCRIPTION DETAILLEE DE L'INVENTION

En référence à la figure 2, l'équipement électronique selon l'invention 20 est ici une passerelle résidentielle qui intègre un assistant vocal.

L'équipement électronique 20 comporte deux sous-ensembles séparables : un premier sous-ensemble 21 et un deuxième sous-ensemble 22.

Le premier sous-ensemble 21 comporte un capot 23 fabriqué en plastique. Le capot 23 comprend un premier trou 24.

Le deuxième sous-ensemble 22 comporte un châssis 25, une carte mère 26, une interface thermique 27, une carte fille 28 et un dissipateur thermique 29.

Le châssis 25 est fabriqué en plastique.

La carte mère 26 comprend un circuit imprimé 30 sur lequel est monté un processeur 31.

La carte fille 28 comprend un circuit imprimé 32 sur lequel est monté un microphone 33. La carte fille 28 est ici une nappe flexible, c'est-à-dire que le circuit imprimé 32 est un circuit imprimé flexible. Cette technologie permet de réduire l'épaisseur du circuit imprimé 32.

Le microphone 33, qui est monté sur la face interne du circuit imprimé 32, est un microphone omnidirectionnel de type MEMS, à port inférieur. Le circuit imprimé 32 comprend un deuxième trou 34.

Le dissipateur thermique 29 est une plaque de cuivre. Le dissipateur thermique 29 comprend un troisième trou 35.

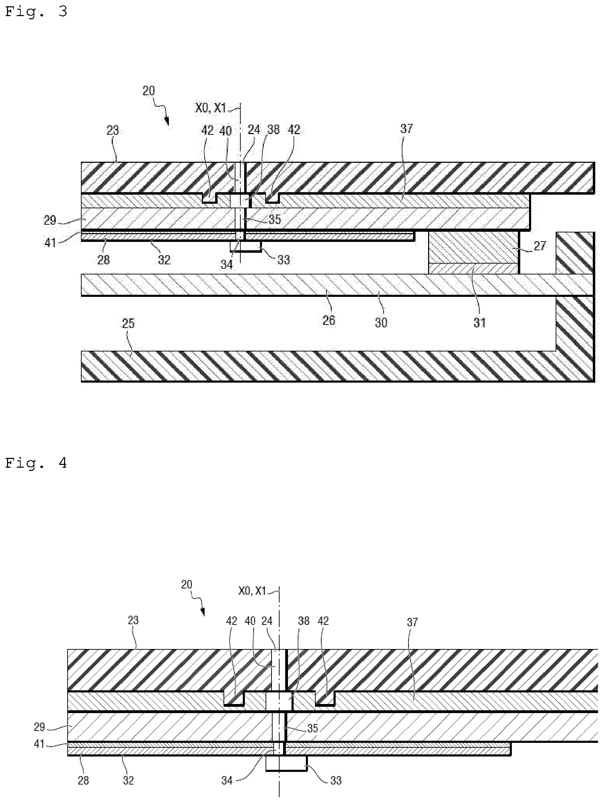

En référence aux figures 3 et 4, l'équipement électronique 20 comporte de plus un pad thermique prédécoupé 37.

Par « pad thermique », on entend une interface thermoconductrice, qui se présente par exemple sous la forme d'une feuille ou d'un film. On parle parfois de tampon d'interface thermique pour désigner un pad thermique. Le pad thermique 37 est compressible. Le pad thermique 37 comprend par exemple du graphite.

Le pad thermique 37 comporte un quatrième trou 38.

Lorsque l'équipement électronique 20 est assemblé, le dissipateur thermique 29 est positionné entre le capot 23 et le circuit imprimé 32 de la carte fille 28, et le pad thermique 37 est positionné entre le capot 23 et le dissipateur thermique 29.

Le premier trou 24, le deuxième trou 34, le troisième trou 35 et le quatrième trou 38 définissent un conduit acoustique 40 agencé pour permettre au microphone 33 de capter des signaux sonores provenant de l'extérieur de l'équipement électronique 20. Le premier trou 24, le deuxième trou 34, le troisième trou 35 et le quatrième trou 38 sont disposés coaxialement, dans l'ordre suivant depuis l'extérieur : premier trou 24, quatrième trou 38, troisième trou 35, deuxième trou 34. Ainsi, les signaux sonores provenant de l'extérieur se propagent dans le conduit acoustique 40 et traversent le circuit imprimé 32 de la carte fille 28 (via le deuxième trou 34) pour atteindre la partie sensible du microphone 33.

Lors de l'assemblage de l'équipement électronique 20, la carte mère 26 est fixée au châssis 25. La face externe de la carte fille 28 est collée à la face interne du dissipateur thermique 29 par une couche d'adhésif thermique 41.

Le dissipateur thermique 29 et l'interface thermique 27 sont disposés de sorte que l'interface thermique 27 est positionnée entre le circuit imprimé 30 de la carte mère 26 et le dissipateur thermique 29. L'interface thermique 27 est en contact avec le processeur 31 et avec le dissipateur thermique 29.

Le pad thermique 37 est déposé sur le dissipateur thermique 29.

Le capot 23 est positionné sur le dissipateur thermique 29.

Il n'y a pas de couche adhésive entre le capot 23 et le dissipateur thermique 29. Le capot 23 et le dissipateur thermique 29 sont désolidarisés et sont séparables (par « séparables », on entend que le capot 23 et le dissipateur thermique 29 peuvent être séparés facilement, rapidement, sans risque de dégrader l'un ou l'autre de ces éléments). Par conséquent, le premier sous-ensemble 21 et le deuxième sous-ensemble 22 sont désolidarisés et séparables.

Le pad thermique 37 est comprimé entre le capot 23 et le dissipateur thermique 29.

Afin de combler le jeu d'air présent entre le dissipateur thermique 29 et le capot 23, et de transférer la chaleur vers le milieu ambiant (c'est-à-dire vers l'extérieur), le pad thermique 37 épouse la forme du dissipateur thermique 29. Le contour du pad thermique 37 admet un décalage de 0.5mm vers l'intérieur par rapport au contour du dissipateur thermique 29, afin d'anticiper les tolérances de fabrication et ainsi d'éviter que le pad thermique 37 ne déborde du dissipateur 29.

Pour garantir que le pad thermique 37 est toujours compressé et assurer ainsi un transfert thermique performant, le pad thermique 37 présente une épaisseur supérieure à un jeu maximal entre le capot 23 et le dissipateur thermique 29 lorsque l'équipement électronique 20 est assemblé. L'épaisseur du pad thermique 37 est par exemple égale à deux fois l'épaisseur du jeu d'air maximal au pire des cas des tolérances de fabrication. Ici, la chaîne de cotes de l'équipement électronique 20 peut former un jeu d'air d'environ 0.2 à 0.3 mm au pire des cas. Le pad thermique 37 a donc ici une épaisseur égale à 0.5 mm.

Le pad thermique 37 présente des propriétés de viscosité qui permettent l'accroche du pad thermique 37 à la fois sur le dissipateur thermique 29 et sur le capot 23, tout en permettant le démontage du capot 23.

Le transfert de chaleur entre le processeur 31 et l'extérieur de l'équipement électronique 20 s'effectue par conduction via l'interface thermique 27, le dissipateur thermique 29, le pad thermique 37 et le capot 23. On note que le capot 23, bien que fabriqué en plastique, permet bien d'évacuer la chaleur vers l'extérieur.

On s'intéresse maintenant plus particulièrement à l'aspect acoustique.

Comme on l'a vu, le pad thermique 37 est comprimé entre le capot 23 et le dissipateur thermique 29. Cependant, la surface du dissipateur thermique 29 est importante, et la seule compression du pad thermique 37 entre la face interne du capot 23 et la face externe du dissipateur thermique 29 ne suffit pas à assurer l'étanchéité acoustique.

La formule suivante permet d'estimer la compression :

$$P = \text{Force (N) / Surface (mm}^2).$$

Ainsi, selon cette formule, il convient pour augmenter la compression de réduire la surface d'appui localement, autour du microphone 33, afin d'augmenter la pression exercée sur le pad thermique 37.

L'équipement électronique 20 comprend donc un élément de compression qui, lorsque l'équipement électronique 20 est assemblé, comprime le pad thermique 37 autour du conduit acoustique 40. L'élément de compression permet d'assurer une étanchéité acoustique du conduit acoustique 40 au niveau du quatrième trou 38, c'est-à-dire à la fois au niveau de l'extrémité externe du quatrième trou 38 (et donc au niveau de l'interface entre le capot 23 et le pad thermique 37), et au niveau de l'extrémité interne du quatrième trou 38 (et donc au niveau de l'interface entre le pad thermique 37 et le dissipateur thermique 29).

L'élément de compression est ici une nervure 42 (on pourrait aussi parler de godron) qui est formée sur la face interne du capot 23. La nervure 42 et le capot 23 forment donc ici une seule et même pièce. La nervure 42 est donc formée au moment de la fabrication du capot 23. Le moule utilisé pour la fabrication du capot 23 comprend une rainure complémentaire permettant d'obtenir la nervure 42.

La nervure 42, qui présente une forme annulaire d'axe X0, s'étend autour du premier trou 24 pratiqué dans le capot 23. La nervure 42 et le premier trou 24 sont disposés coaxialement, c'est-à-dire que l'axe X0 et l'axe X1 sont confondus, l'axe X1 étant l'axe du premier trou 24 mais aussi du conduit acoustique 40 lorsque l'équipement électronique 20 est assemblé.

Ainsi, lors de l'assemblage de l'équipement électronique 20, le pad thermique 37 est positionné sur le dissipateur thermique 29, puis le capot 23 est disposé sur le pad thermique 37. Le capot 23 comprime le pad thermique 37. La compression est plus importante au niveau de la nervure 42, ce qui permet de garantir l'étanchéité acoustique du conduit acoustique 40 au niveau du pad thermique 37.

Les dimensions de la nervure 42 sont choisies de manière à répondre à plusieurs contraintes.

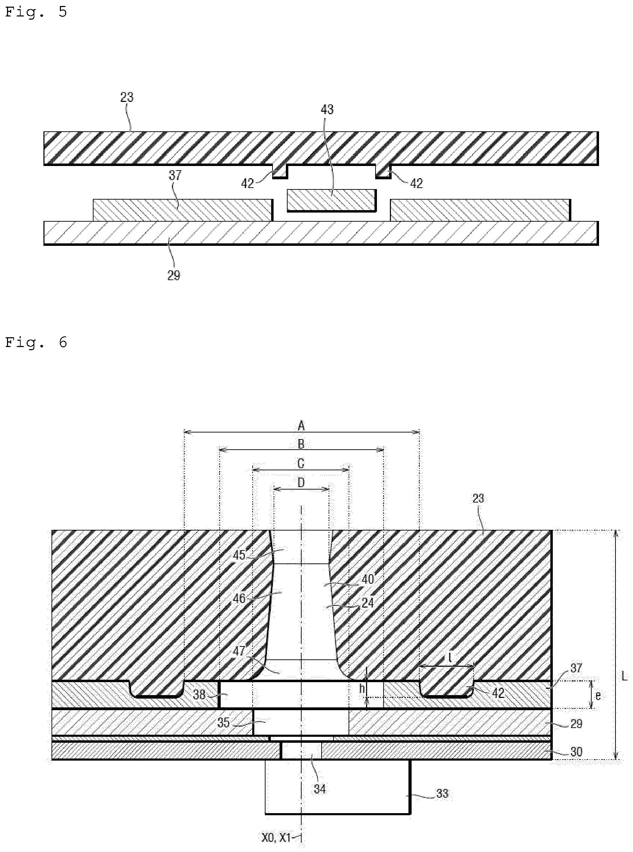

Tout d'abord, en référence à la figure 5, une nervure 42 trop saillante peut entraîner un phénomène de poinçonnement du pad thermique 37 du fait de son matériau ultra-compressible. Une portion 43 partiellement ou entièrement poinçonnée peut alors apparaître dans le pad thermique 37 entraînant la perte de l'étanchéité acoustique.

Pour répondre à cette problématique, en référence à la figure 6, la nervure 42 est conçue de sorte qu'une largeur l de la nervure, égale à une différence entre un rayon extérieur et un rayon intérieur de la nervure 42, et une hauteur h de la nervure 42, sont telles que :

$$l \geq 3 \times h.$$

Par ailleurs, pour assurer localement une compression suffisante et éviter toute fuite entre le conduit acoustique 40 et le milieu ambiant, on prévoit que la hauteur h est telle que :

$$h \geq 0,5 \times e,$$

où e est l'épaisseur du pad thermique 37.

Le conduit acoustique 40 se présente donc sous la forme d'un tube fermé à une extrémité par la membrane du microphone 33 et ouvert sur l'extérieur de l'équipement électronique 20 à l'autre extrémité.

Le conduit acoustique 40 constitue un milieu propice à la formation d'ondes stationnaires. La fréquence fondamentale d'un tube, à laquelle aura lieu la première occurrence d'onde stationnaire, est inversement proportionnelle à sa longueur et à son diamètre selon la relation suivante :

$$f_1 = \frac{v}{4 \, x \, (L + 0,4 \times d)},$$

L étant la longueur du conduit acoustique, d son diamètre et v la célérité du son dans le milieu ambiant.

Cette fréquence peut être source de perturbations importantes dans les signaux sonores reçus par le microphone 33 et doit se situer hors de la plage de fréquence utile, soit, dans le cas de la reconnaissance vocale, au-delà de 8kHz. Ainsi, le diamètre du conduit acoustique 40 et sa longueur doivent être choisis en conséquence.

On choisira avantageusement un diamètre d'entrée du conduit acoustique 40 égal à 1mm, et une longueur L du conduit acoustique 40 qui n'excède pas 10mm. Le diamètre d'entrée du conduit acoustique 40 est le diamètre de l'extrémité externe du premier trou 24.

De même, afin de garantir la continuité du conduit acoustique 40 et de contourner les possibles défauts de positionnement liés aux tolérances de fabrication et d'assemblage, les différentes pièces constitutives du conduit acoustique 40 sont percées de sorte que D < C < B < A, où D est un diamètre moyen du premier trou 24 pratiqué dans le capot 23 (c'est à dire le diamètre moyen de l'orifice d'entrée du conduit acoustique 40), C est le diamètre moyen du troisième trou 35 (c'est-à-dire du perçage dans le dissipateur thermique 29), B est le diamètre moyen du quatrième trou 38 pratiqué dans le pad thermique 37, et A est le diamètre intérieur de la nervure annulaire 42. Par « diamètre moyen » d'un trou, on entend la moyenne du diamètre du trou sur sa longueur.

On note que le premier trou 24 comporte une portion conique d'entrée 45 (qui débouche sur la face externe du capot 23), une portion conique centrale 46 et une portion évasée 47 (qui débouche sur la face interne du capot 23). La forme du premier trou 24 est due au procédé de fabrication du capot 23 (par injection plastique).

Les sous-ensembles de l'équipement électronique 20 sont donc démontables pour garantir le recyclage optimal des différents éléments, en particulier les éléments plastiques (dont le capot 23).

L'équipement électronique selon l'invention 20 permet de répondre, de manière fiable, économique et écologique, aux problématiques de SAV et de recyclage, tout en assurant d'excellentes performances thermiques et acoustiques (et notamment au niveau des interfaces des pièces mécaniques impactées par la solution).

Bien entendu, l'invention n'est pas limitée au mode de réalisation décrit mais englobe toute variante entrant dans le champ de l'invention telle que définie par les revendications.

On a décrit ici que l'élément de compression est une nervure formée sur une face interne du capot. Cette solution n'est aucunement limitative. L'élément de compression pourrait par exemple être une nervure formée sur la face externe du dissipateur thermique. La nervure s'étend alors autour du troisième trou pratiqué dans le dissipateur thermique. L'élément de compression pourrait aussi être une pièce distincte du capot et du dissipateur thermique, par exemple une bague positionnée entre le pad thermique et le capot au moment de l'assemblage de l'équipement électronique.

On a évoqué ici un seul microphone, mais l'équipement électronique peut bien sûr comprendre une pluralité de microphones et donc une pluralité de conduits acoustiques agencés comme celui décrit ici.

L'équipement électronique n'est bien sûr pas nécessairement une passerelle résidentielle, mais peut être tout équipement électronique comprenant un microphone : enceinte connectée, assistant vocal, boîtier décodeur, tablette, *smartphone,* etc.

**Revendications**

**1.** Equipement électronique (20) comportant un premier sous-ensemble (21) et un deuxième sous-ensemble (22) séparables, le premier sous-ensemble comprenant un capot (23) comportant un premier trou (24), le deuxième sous-ensemble comprenant un circuit imprimé (32) sur lequel est monté au moins un microphone (33) et comprenant un deuxième trou (34), et un dissipateur thermique (29) comprenant un troisième trou (35), l'équipement électronique (20) comportant de plus un pad thermique (37) comprenant un quatrième trou (38), et un élément de compression (42), l'équipement électronique étant agencé de sorte que, lorsque l'équipement électronique est assemblé, le dissipateur thermique est positionné entre le capot et le circuit imprimé, le pad thermique est positionné entre le capot et le dissipateur thermique, le premier trou, le deuxième trou, le troisième trou et le quatrième trou définissent un conduit acoustique (40) agencé pour permettre au microphone de capter des signaux sonores provenant de l'extérieur de l'équipement électronique, et l'élément de compression comprime le pad thermique autour du conduit acoustique pour assurer une étanchéité acoustique du conduit acoustique au niveau d'une interface entre le capot et le pad thermique et au niveau d'une interface entre le pad thermique et le dissipateur thermique.

**2.** Equipement électronique selon la revendication 1, dans lequel l'élément de compression (42) est une nervure formée sur le capot (23) ou sur le dissipateur thermique (29).

**3.** Equipement électronique selon la revendication 2, dans lequel la nervure (42) est formée sur une face interne du capot (23) et s'étend autour du premier trou (24).

**4.** Equipement électronique selon la revendication 2, dans lequel la nervure est formée sur une face externe du dissipateur thermique (29) et s'étend autour du troisième trou (35).

**5.** Equipement électronique selon la revendication 2, dans lequel la nervure (42) présente une forme annulaire, et dans lequel une largeur l de la nervure égale à une différence entre un rayon extérieur et un rayon intérieur de la nervure, et une hauteur h de la nervure, sont telles que :

$$l \geq 3 \times h.$$

**6.** Equipement électronique selon la revendication 2, dans lequel une hauteur h de la nervure et une épaisseur e du pad thermique (37) sont telles que :

$$h \geq 0,5 \times e.$$

**7.** Equipement électronique selon la revendication 2, dans lequel on a :

$$D < C < B < A,$$

où D est un diamètre moyen du premier trou (24), C est un diamètre moyen du troisième trou (35), B est un diamètre moyen du quatrième trou (38) et A est un diamètre intérieur de la nervure (42).

**8.** Equipement électronique selon l'une des revendications précédentes, dans lequel le pad thermique (37) comprend du graphite.

9. Equipement électronique selon l'une des revendications précédentes, dans lequel le circuit imprimé (32) est fixé au dissipateur thermique (29) par une couche d'adhésif thermique (41).

10. Equipement électronique selon l'une des revendications précédentes, l'équipement électronique (20) étant une passerelle résidentielle ou un boîtier décodeur.

**Patentansprüche**

1. Elektronisches Gerät (20), umfassend eine erste Untereinheit (21) und eine zweite Untereinheit (22), die trennbar sind, wobei die erste Untereinheit eine Abdeckung (23) umfasst, die ein erstes Loch (24) enthält, wobei die zweite Untereinheit eine Leiterplatte (32) umfasst, auf der mindestens ein Mikrofon (33) montiert ist und die ein zweites Loch (34) enthält, und einen Kühlkörper (29), der ein drittes Loch (35) enthält, wobei das elektronische Gerät (20) ferner ein Wärmeleitpad (37) umfasst, das ein viertes Loch (38) enthält, und ein Kompressionselement (42), wobei das elektronische Gerät derart ausgebildet ist, dass, wenn das elektronische Gerät zusammengesetzt ist, der Kühlkörper zwischen der Abdeckung und der Leiterplatte positioniert ist, das Wärmeleitpad zwischen der Abdeckung und dem Kühlkörper positioniert ist, das erste Loch, das zweite Loch, das dritte Loch und das vierte Loch einen Akustikkanal (40) definieren, der so ausgebildet ist, dass er dem Mikrofon das Aufnehmen von Tonsignalen ermöglicht, die von außerhalb des elektronischen Geräts stammen, und das Kompressionselement das Wärmeleitpad um den Akustikkanal herum komprimiert, um eine akustische Dichtheit des Akustikkanals im Bereich einer Schnittstelle zwischen der Abdeckung und dem Wärmeleitpad und im Bereich einer Schnittstelle zwischen dem Wärmeleitpad und dem Kühlkörper sicherzustellen.

2. Elektronisches Gerät nach Anspruch 1, bei dem das Kompressionselement (42) eine Rippe ist, die auf der Abdeckung (23) oder auf dem Kühlkörper (29) ausgebildet ist.

3. Elektronisches Gerät nach Anspruch 2, bei dem die Rippe (42) auf einer Innenfläche der Abdeckung (23) ausgebildet ist und sich um das erste Loch (24) herum erstreckt.

4. Elektronisches Gerät nach Anspruch 2, bei dem die Rippe auf einer Außenfläche des Kühlkörpers (29) ausgebildet ist und sich um das dritte Loch (35) herum erstreckt.

5. Elektronisches Gerät nach Anspruch 2, bei dem die Rippe (42) eine ringförmige Form aufweist und bei dem eine Breite l der Rippe gleich der Differenz zwischen einem Außenradius und einem Innenradius der Rippe und eine Höhe h der Rippe derart sind, dass:

$$l \geq 3xh.$$

6. Elektronisches Gerät nach Anspruch 2, bei dem eine Höhe h der Rippe und eine Dicke e des Wärmeleitpads (37) derart sind, dass:

$$h \geq 0{,}5xe.$$

7. Elektronisches Gerät nach Anspruch 2, bei dem man hat:

$$D < C < B < A,$$

wobei D ein mittlerer Durchmesser des ersten Lochs (24), C ein mittlerer Durchmesser des dritten Lochs (35), B ein mittlerer Durchmesser des vierten Lochs (38) und A ein Innendurchmesser der Rippe (42) ist.

8. Elektronisches Gerät nach einem der vorhergehenden Ansprüche, bei dem das Wärmeleitpad (37) Graphit umfasst.

9. Elektronisches Gerät nach einem der vorhergehenden Ansprüche, bei dem die Leiterplatte (32) an dem Kühlkörper (29) über eine Thermoklebstoffschicht (41) befestigt ist.

**10.** Elektronisches Gerät nach einem der vorhergehenden Ansprüche, wobei das elektronische Gerät (20) ein Residential Gateway oder eine Set-Top-Box ist.

**Claims**

**1.** Electronic equipment (20) comprising a first subassembly (21) and a second subassembly (22) that are separable, the first subassembly comprising a cover (23) including a first hole (24), the second subassembly comprising both a printed circuit (32) having at least one microphone (33) mounted thereon and including a second hole (34), and also a heatsink (29) including a third hole (35), the electronic equipment (20) further comprising a thermal pad (37) including a fourth hole (38), and a compression element (42), the electronic equipment being arranged in such a manner that, once the electronic equipment is assembled, the heatsink is positioned between the cover and the printed circuit, the thermal pad is positioned between the cover and the heatsink, the first hole, the second hole, the third hole, and the fourth hole together define an acoustic duct (40) that is arranged to enable the microphone to pick up sound signals coming from outside the electronic equipment, and the compression element compresses the thermal pad around the acoustic duct in order to ensure sound-proofing of the acoustic duct at an interface between the cover and the thermal pad and at an interface between the thermal pad and the heatsink.

**2.** Electronic equipment according to claim 1, wherein the compression element (42) is a rib formed on the cover (23) or on the heatsink (29).

**3.** Electronic equipment according to claim 2, wherein the rib (42) is formed on an inside face of the cover (23) and extends around the first hole (24).

**4.** Electronic equipment according to claim 2, wherein the rib is formed on an outside face of the heatsink (29) and extends around the third hole (35).

**5.** Electronic equipment according to claim 2, wherein the rib (42) is annular in shape, and wherein the rib has both a width $\ell$ equal to the difference between an outside radius and an inside radius of the rib, and also a height $\underline{h}$ such that:

$$\ell \geq 3 \times h.$$

**6.** Electronic equipment according to claim 2, wherein the rib has a height $\underline{h}$ and the thermal pad (37) has a thickness $\underline{e}$ such that:

$$h \geq 0.5 \times e.$$

**7.** Electronic equipment according to claim 2, wherein the following applies:

$$D < C < B < A,$$

where D is the mean diameter of the first hole (24), C is the mean diameter of the third hole (35), B is the mean diameter of the fourth hole (38), and A is the inside diameter of the rib (42).

**8.** Electronic equipment according to any preceding claim, wherein the thermal pad (37) comprises graphite.

**9.** Electronic equipment according to any preceding claim, wherein the printed circuit (32) is fastened to the heatsink (29) by a layer (41) of thermal adhesive.

**10.** Electronic equipment according to any preceding claim, the electronic equipment (20) being a home gateway or a decoder box.

Fig. 1

Fig. 2

Fig. 3

Fig. 4

Fig. 5

Fig. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2020032515 A
- WO 2020143315 A